# EUROPEAN PATENT APPLICATION

(11) **EP 2 144 119 A1**
(43) Date of publication of application: **13.01.2010**
(21) Application number: 09159665.0
(22) Date of filing: 25.12.2006
(51) Int. Cl.: G03F 7/20

(54) **Reticle transport apparatus and reticle transporting method**

(30) Priority: 28.12.2005 JP 2005377668
(62) Divisional of application: 06843136.0
(71) Applicant: Nikon Corporation, Tokyo 100-8331 (JP)
(72) Inventor: Yamamoto, Hajime, Tokyo 100-8331 (JP)
(74) Representative: Hooiveld, Arjen Jan Winfried

(57) **Abstract**

There is provided a reticle transport apparatus which is capable of preventing any foreign matter from adhering to a reticle. A reticle transport apparatus (4), which transports a reticle with respect to a processing atmospheric chamber (3), includes a reticle loading mechanism (4) which loads the reticle into a processing atmosphere chamber (3), at least a region of the reticle in which a pattern is formed being covered by a cover; a cover unloading mechanism (4) which unloads, out of the processing atmosphere chamber (3), the cover separated from the reticle after the reticle has been transported by the reticle loading mechanism (4); and a cover cleaning mechanism (10) which cleans the cover unloaded by the cover unloading mechanism (4).

## Description

### TECHNICAL FIELD

The present invention relates to a reticle transport apparatus which transports a reticle with respect to an exposure atmosphere chamber, an exposure apparatus, a reticle transporting method, a reticle processing method, a device producing method, and a reticle cover managing method.

### BACKGROUND ART

In the recent years, the realization of a projection exposure apparatus, which exposes a pattern of a reticle onto a photosensitive substrate using extreme ultraviolet (EUV) light in the wavelength range of approximately 5 to 40 nm as the exposure light, is advanced. Since EUV light is absorbed by air, in an EUVL (extreme ultraviolet light lithography) exposure apparatus, a high degree of vacuum needs to be maintained within a chamber accommodating the apparatus, and special contrivances are necessary also during the transportation of reticles.

As a reticle usable for the EUVL exposure apparatus, a reflecting type reticle is used because there is not much glass materials having a high transmittivity with respect to short wavelength light. For a reticle in an exposure apparatus using normal visible light or ultraviolet ray, a transparent thin film called a pellicle is used for the purpose of protecting a pattern surface of the reticle. However, the pellicle cannot be formed in a EUV exposure apparatus because there are few materials which have high transmittivity with respect to short wavelength light. Therefore, upon transporting and storing a reticle, the reticle is covered with a protective cover (protective member) to protect the pattern region of the reticle (see, for example, United States Patent No. 6, 239, 863).

Upon transporting the reticle while the reticle is protected by the protective cover, it is inevitable that the reticle and the protective cover contact with each other, which in turn generates dust at a contact point between the reticle and the protective cover. When the reticle is transported repeatedly, any foreign matter or foreign body generated due to the generated dust thus accumulates, thereby causing a problem that the pattern region of the reticle is polluted or dirtied by the foreign matter.

### DISCLOSURE OF THE INVENTION

An object of the present invention is to provide a reticle transport apparatus which is capable of preventing foreign matter from adhering to the reticle, an exposure apparatus provided with the reticle transport apparatus, a reticle transporting method and a reticle processing method.

According to a first aspect of the present invention, there is provided a reticle transport apparatus which transports a reticle with respect to a processing atmosphere chamber, the reticle transport apparatus comprising: a reticle loading mechanism which loads the reticle into the processing atmosphere chamber, at least a portion of the reticle being covered by a cover; a cover unloading mechanism which unloads, out of the processing atmosphere chamber, the cover which is separated from the reticle after the reticle has been loaded into the processing atmosphere chamber by the reticle loading mechanism; and a cover cleaning mechanism which cleans the cover unloaded by the cover unloading mechanism.

According to a second aspect of the present invention, there is provided an exposure apparatus which transfers a pattern formed on a reticle onto a photosensitive substrate, the exposure apparatus comprising the reticle transport apparatus according to the first aspect of the invention.

According to a third aspect of the present invention, there is provided an exposure apparatus which transfers, onto a photosensitive substrate, a pattern formed on a reticle arranged in an exposure atmosphere chamber, the exposure apparatus comprising: a reticle loading mechanism which loads the reticle into the exposure atmosphere chamber, at least a portion of the reticle being covered by a cover; a cover separating mechanism which separates the cover from the reticle after the reticle has been loaded into the exposure atmosphere chamber by the reticle loading mechanism; and a cover unloading mechanism which unloads the cover out of the exposure atmosphere chamber while the reticle from which the cover has been separated by the cover separating mechanism remains in the exposure atmosphere chamber.

According to a fourth aspect of the present invention, there is provided a reticle transporting method for transporting a reticle with respect to a processing atmosphere chamber, the method comprising: loading the reticle into the processing atmosphere chamber, at least a portion of the reticle being covered by a cover; unloading the cover, separated from the reticle after the reticle has been loaded into the processing atmosphere chamber, out of the processing atmosphere chamber; and cleaning the unloaded cover.

According to a fifth aspect of the present invention, there is provided a reticle processing method for performing a predetermined process for a reticle, the method comprising: transporting the reticle to a desired position, at least a portion of the reticle being covered with a cover; separating the cover and the reticle; performing the predetermined process for the separated reticle; and covering the reticle, for which the predetermined process has been performed, with a cover different from the cover. In this case, although the predetermined process is not specifically limited, the predetermined process may be exemplified by an exposure process for irradiating an illumination light to the reticle and transferring a pattern, which is formed on the reticle, onto a photosensitive substrate, and exposing the reticle with the pattern.

According to a sixth aspect of the present invention, there is provided a method for producing a device, comprising: using the reticle processing method according to the fifth aspect of the present invention; performing an exposure process as the predetermined process; and producing the device from the photosensitive substrate exposed by the exposure process.

According to a seventh aspect of the present invention, there is provided a method for managing a reticle cover, comprising determining timing of exchanging or cleaning the reticle cover using characteristic unique to the reticle cover.

According to the reticle transport apparatus of the first aspect of the present invention, the reticle transport apparatus is provided with the cover cleaning mechanism which cleans the cover for covering at least a region, of the reticle, in which the pattern is formed. Therefore, it is possible to remove foreign matter adhering to the cover. This makes it possible to prevent the foreign matter adhering to the reticle in a state that the reticle is covered by the cover.

According to the exposure apparatus of the second aspect of the present invention, the exposure apparatus is provided with the reticle transport apparatus of the first aspect. Therefore, it is possible to clean the cover which covers at least a portion or part of the reticle, thereby making it possible to remove foreign matter adhered to the cover. Accordingly, it is possible to prevent foreign matter from adhering to the reticle in a state that the reticle is covered with the cover, realizing satisfactory exposure.

According to the exposure apparatus of the third aspect of the present invention, it is possible to unload the cover to the outside of the exposure atmosphere chamber while the reticle remains in the exposure atmosphere, namely in a state that the cover for covering at least a portion of the reticle is separated from the reticle. Accordingly, it is possible to inspect whether any dirt or foreign matter is adhered to the cover unloaded out of the exposure atmosphere chamber, and/or it is possible to clean the cover and/or exchange the cover.

According to the reticle transporting method of the fourth aspect of the present invention, the cover covering at least a portion or part of the reticle is cleaned, thereby making it possible to remove the foreign matter adhering to the cover. Therefore, it is possible to prevent any foreign matter from adhering to the reticle when the reticle is covered with the cover.

According to the reticle processing method of the fifth aspect of the present invention, the reticle is covered by a new cover after a process such as exposure, etc. has been performed for the reticle. Thus, any dirtied cover would not be used, preventing the reticle from being polluted or dirtied by the dirtied cover.

According to the device producing method of the sixth aspect of the present invention, a clean reticle is used to perform exposure process for a photosensitive substrate. Therefore, a high-quality device can be produced with high productivity and low rejection rate.

According to the method for managing reticle cover of the seventh aspect of the present invention, timing of exchanging or cleaning the reticle cover can be determined appropriately.

### BRIEF DESCRIPTION OF THE DRAWINGS

Fig. 1 is a diagram showing the construction of an exposure apparatus according to a first embodiment.
Fig. 2 shows the construction of a protective cover according to the first embodiment.
Fig. 3 is an exploded view for explaining the construction of the protective cover according to the first embodiment.
Fig. 4 is a view for explaining the construction of a reticle according to the first embodiment.
Fig. 5 is a view for explaining the construction of a prealignment chamber according to the first embodiment.
Fig. 6 is a flow chart for explaining a reticle transporting method according to the first embodiment.
Fig. 7 is a diagram showing the construction of an exposure apparatus according to a second embodiment.

### BEST MODE FOR CARRYING OUT THE INVENTION

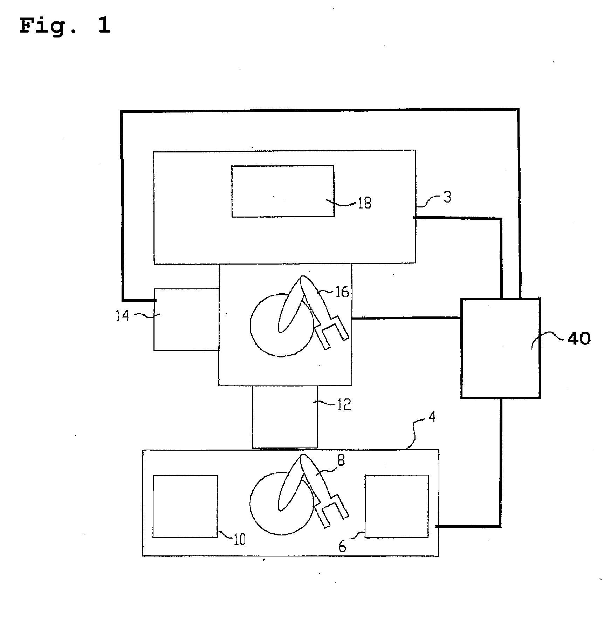

In the following, an exposure apparatus according to the first embodiment of the present invention will be explained with reference to the drawings. Fig. 1 shows a schematic view showing the construction of the exposure apparatus according to the first embodiment. As shown in Fig. 1, the exposure apparatus is provided with an exposure section 3 which exposes a pattern formed on a reticle onto a photosensitive substrate; and a reticle transport section (reticle transport apparatus) 4 which loads and unloads the reticle into and out of (with respect to) the exposure section 3 via a load lock chamber 12. The load lock chamber 12 will be described later on.

The reticle transport section 4 is provided with an air reticle library 6 accommodating a plurality of reticles on which various patterns are formed; an air-side robot 8 which loads a predetermined reticle, among the reticles, from the air reticle library 6 and transports the predetermined reticle to the load lock chamber 12; and a cleaning chamber 10 in which a protective cover covering the reticle is cleaned. In the air reticle library 6, the reticles are accommodated in a state that each of the reticle is covered by a protective cover. A surface of each of the reticles, on which a pattern is formed, is covered by the protective cover prepared corresponding to each of the reticles.

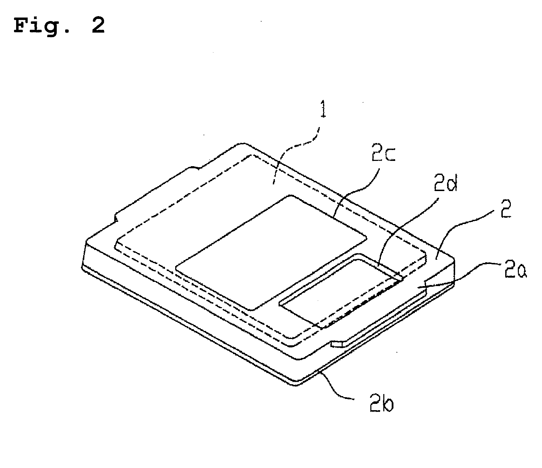

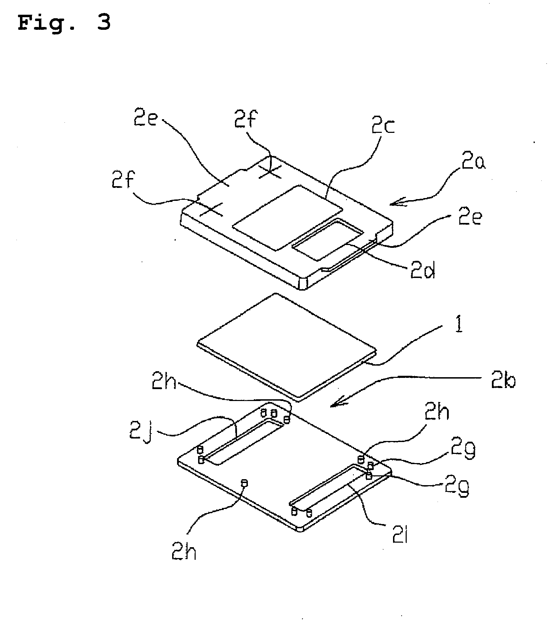

Fig. 2 shows the construction of a protective cover 2 which covers a reticle 1, and Fig. 3 is an exploded view for explaining the construction of the protective cover 2. As shown in Figs. 2 and 3, the protective cover 2 includes an upper cover 2a and a lower cover 2b. The upper cover 2a is formed, for example, of a metal such as aluminum, and has a filter 2c and a transparent window 2d. The filter 2c is constructed so as to promote an adequate air flow in the protective cover 2, while preventing fine particles such as debris, dust, etc. from entering into the interior of the protective cover 2. As will be described later, the protective cover 2 goes back and forth between an ambient air space (atmospheric space) and a vacuum space. Therefore, even when the upper cover 2a and the lower cover 2b of the protective cover 2 are engaged with each other to form an interior space, the air pressure difference is reduced, by the filter 2c, between the interior space of the protective cover 2 and the space outside the protective cover 2 such that any force resulting from the pressure difference is not exerted on the upper cover 2a and the lower cover 2b. The transparent window 2d is provided so that the state of the reticle 1 can be observed from outside the protective cover 2.

Further, the upper cover 2a is provided with two projections 2e at two locations on the left and right sides, respectively, in the sheet surface of the drawing. These two projections 2e are caught on and held by an unillustrated holding member; the lower cover 2b is lowered to separate the upper cover 2a and the lower cover 2b. Furthermore, the upper cover 2a is provided with two position detection marks 2f, with which the position of the upper cover 2a is detected by measuring the position detection marks 2f using an unillustrated position measurement device.

The lower cover 2b is formed, for example, of a metal such as aluminum, and is provided with positioning pins 2g arranged as in pairs of two in the four corners respectively of the lower cover 2b, and reticle holding projections 2h arranged on the lower cover 2b in three locations respectively. The positioning pins 2g position the reticle 1 in the planar direction when holding the reticle 1. The reticle holding projections 2h support the reticle 1 at three points.

Moreover, the lower cover 2b is provided with two transparent windows 2i, 2j which are made of glass, etc., and via which a mark and/or an ID mark formed on the reticle 1 are observed from below the lower cover 2b. Fig. 3 shows an example provided with two transparent windows 2i, 2j. However, in a case that the positions of the mark and/or ID mark are fixed on the reticle 1, it is sufficient that the lower case 2b is provided with only one transparent window. The reticle 1 is accommodated or stored in the air reticle library 6 in a state as shown in Fig. 2 that the reticle is accommodated in the protective cover 2.

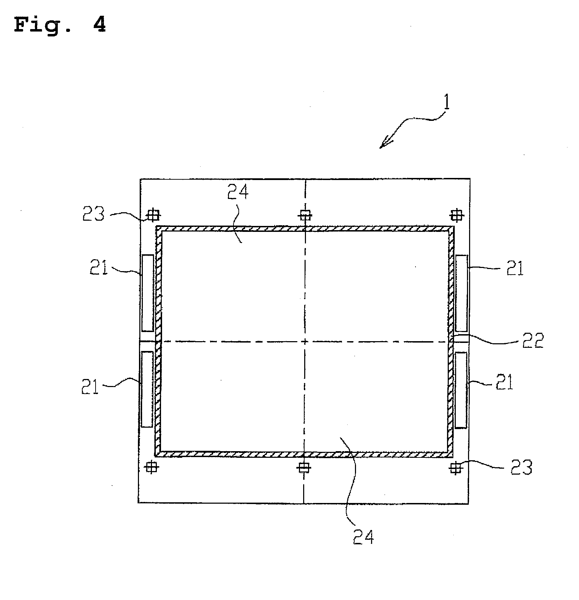

As a pattern surface of the reticle 1, an exemplary construction as shown in Fig. 4 is conceivable.
Fig. 4 is a plan view showing the pattern surface of the reticle 1 shown in Fig. 3 as seen therebelow. The pattern surface of the reticle 1 has a pattern region 24 in which a pattern such as a semiconductor circuit to be transferred onto a wafer is formed in a central portion of the pattern surface; a non-reflection region 22 which is arranged to surround the pattern region 24 and which is formed of an absorbing body, etc.; reference reflecting surfaces 21 which is arranged outside the pattern region 24; and a mark region 23 which is arranged outside the pattern region 24 and in which a positioning mark and/or an ID mark are formed. It is preferable that the protective cover 2 covers and protects at least the pattern region 24 of the reticle 1; and further preferable that the protective cover 2 covers and protects the entirety of the pattern surface of the reticle 1, furthermore covers and protects the entirety of the reticle 1, thereby protecting the reticle 1 in view of problem such as adhesion of debris, dust, etc. Although this embodiment adopts the protective cover configured to cover the entire reticle 1 with the upper cover 2a and the lower cover 2b, it is also possible to use, as the protective cover, in the present invention a publicly known protective cover disclosed, for example, in the specification of the United State Patent No. 6,239,863 mentioned in the "Background Art". For example, it is possible to use a protective cover which protects only the pattern surface of the reticle 1, or protects only the pattern region of the reticle 1. In addition, the present invention may be used even in a case using those different from the above-described reticle covers, and is applicable to a reticle cover which covers at least a portion or part of the reticle.

Further, the exposure apparatus is provided with the load lock chamber 12 which receives a reticle 1 transported from the reticle transport section 4; a prealignment chamber 14 which performs prealignment of the reticle 1; the exposure section 3; and a vacuum-side robot 16 which transports the reticle 1 and the protective cover 2 between the load lock chamber 12 and the prealignment chamber 14. The exposure section 3, the prealignment chamber 14, and the vacuum-side robot 16 are accommodated in a vacuum atmosphere chamber (exposure atmosphere chamber, processing atmosphere chamber). Further, the load lock chamber 12 is configured for vacuum exhaustible and releasable to the air.

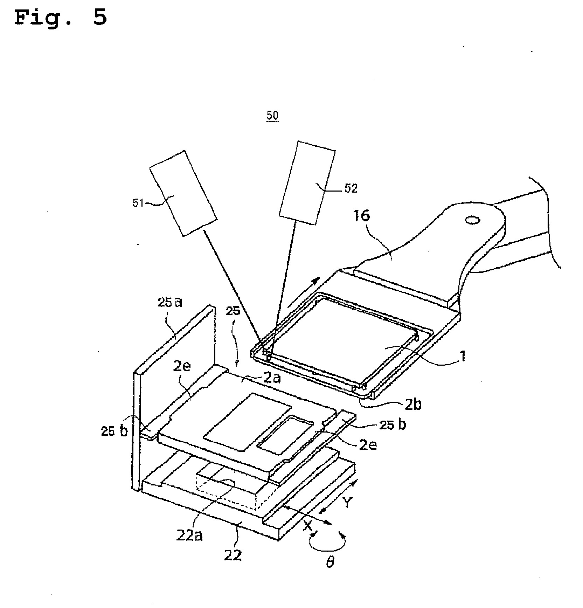

Fig. 5 is a schematic view of the construction of the prealignment chamber 14 which has a CFP opener 25, showing the construction of the CFP opener 25 as well as a state that the protective cover 2 is separated into the upper cover 2a and the lower cover 2b and that the reticle 1 is taken out (separated, removed) from the protection cover 2 while the reticle 1 is placed on the lower cover 2b.

The CFP opener 25 is a one-level rack having a horizontal plate 25b and vertical plates 25a (only one of the vertical plates 25a is shown, while the other vertical plate 25a is omitted from the drawing). In the CFP opener 25, the projections 2e of the upper cover 2a are caught or received onto the horizontal plate 25b to thereby suspend the upper plate 2a.

When the protective cover 2 is lowered onto the horizontal plate 25b from a position above or over the horizontal plate 25b in a state that an end portion of the vacuum-side robot 16 supports the lower surface of the lower cover 2b, then the projections 2e of the upper cover 2a are caught on the horizontal plate 25b. When the vacuum-side robot 16 is further lowered to a lower position, then the lower cover 2b and the reticle 1 placed on the lower cover 2b are also lowered further, while the upper cover 2a remains to be held on the horizontal plate 25b, as shown in the drawing, because the projections 2e are caught on the horizontal plate 25b. Thus, the upper cover 2a is separated from the lower cover 2b and the reticle 1. In this state, when the vacuum-side robot 16 is pulled in a direction indicated by an arrow in the drawing, then the reticle 1, which is placed on the lower cover 2b, can be taken out.

The CFP opener 25 is provided with an alignment stage 22. As shown in the drawing, the alignment stage 22 is movable in an X direction and a Y direction perpendicular to the X direction, and is capable of making rotation (θ) around a Z direction axis perpendicular to the X and the Y directions. In this example, although the horizontal plate 25b onto which the upper cover 2a is placed is fixed, it is also possible to provide a drive means to move the horizontal plate 25b when it is desired to adjust the position of the upper cover 2a.

When it is desired to prealign the reticle 1 (to perform alignment of the reticle 1), the vacuum-side robot 16 is lowered in a state that the end portion of the vacuum-side robot 16 pinches or holds the lower cover 2b on which the reticle 1 is placed, thereby making it possible to place the lower cover 2b on the alignment stage 22. The central portion of the alignment stage 22 is shaped to have a protruding portion so that the vacuum-side robot 16 can be lowered up to a position at which the end portion of the vacuum-side robot 16 does not come into contact with the lower cover 2b in a state that the lower cover 2b is placed on the alignment stage 22. A through hole 22a is provided at the central portion of the alignment stage 22 such that the position of the lower cover 2b and the position of the reticle 1 can be detected by a position detecting device. Further, it is possible to perform prealignment of the reticle 1 by moving the alignment stage 22.

The exposure section 3 is provided with a reticle holder 18 which supports or holds the reticle 1 loaded by the vacuum-side robot 16. The reticle holder 18 attracts, by an electrostatic chuck or the like, a surface, of the reticle 1, which is on the opposite side of the pattern surface of the reticle 1 shown in Fig. 4. In a state that the reticle 1 is supported by the reticle holder 18, a light radiated from an unillustrated light source illuminates the pattern of the reticle 1 via an unillustrated illumination optical system, and the illuminated pattern is projected onto a photosensitive substrate via an unillustrated projection optical system, thereby transferring the pattern of the reticle 1 onto the photosensitive substrate and exposing the substrate with the pattern of the reticle 1.

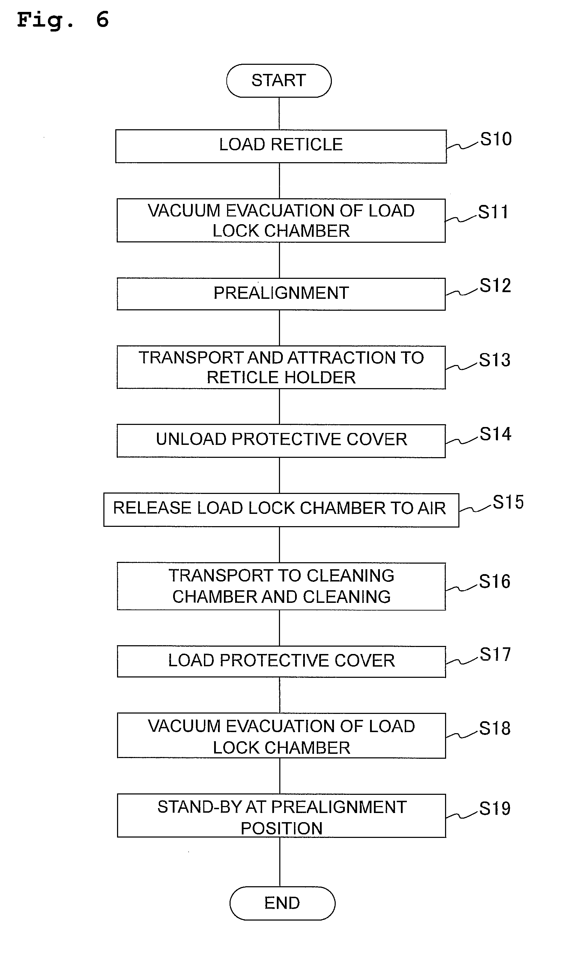

Next, an explanation will be given, with reference to the flow chart shown in Fig. 6, about a reticle transporting method for transporting the reticle 1 with respect to the exposure section 3 with the reticle transporting section 4 according to the first embodiment.

First, the air-side robot 8 is used to taken out the reticle 1, protected by the protective cover 2, from the air reticle library 6 and to load the reticle 1 into the load lock chamber 12 (Step S10).

Next, after loading in Step S10 the reticle 1, protected by the protective cover 2, into the lock chamber 12, the load lock chamber 12 is evacuated (subjected to vacuum evacuation) to make the atmosphere inside the load lock chamber 12 to be vacuum atmosphere, for the purpose of loading the reticle 1 into the exposure section 3 having vacuum atmosphere (Step S11). At this time, the interior of the protective cover 2 is also evacuated to have the vacuum atmosphere. Next, the vacuum-side robot 16 is used to taken out the reticle 1, covered by the protective cover 2 as described above, from the load lock chamber 12, and to load the reticle 1 into the prealignment chamber 14, where the reticle 1 is pre-aligned (Step S12). At this time, the upper cover 2a of the protective cover 2 is removed.

Next, the vacuum-side robot 16 is used to take out the reticle 1, covered by the lower cover 2b of the protective cover 2, from the prealignment chamber 14. Then, the reticle 1 is transported or loaded to the reticle holder 18 provided on the exposure section 3 (reticle loading step); and the reticle is made to be attracted to the reticle holder 18 (Step S13), and the lower cover 2b of the protective cover 2 is removed. Next, after attracting the reticle 1 to the reticle holder 18 in Step S13, the vacuum-side robot 16 is used to unload the protective cover 2, including the upper cover 2a and the lower cover 2b which have been covering the reticle 1, out of the exposure section 3 (Step S14: protective cover unloading step) and to load the protective cover 2 into the load lock chamber 12. Note that upon changing the atmosphere of the load lock chamber 12 from the vacuum atmosphere to air atmosphere, there is a possibility that any debris, dust, etc. might fly about within the load lock chamber 12. Therefore, it is preferable that the upper cover 2a and the lower cover 2b are closed during the unloading to prevent any debris and/or dust from entering the interior space of the protective cover 2.

Next, after loading the protective cover 2 into the load lock chamber 12, the load lock chamber 12 is opened or released to the air, thereby making the inside the load lock chamber 12 to connect to or communicate with the air atmosphere (Step S15). At this time, the interior of the protective cover 2 is also opened to the air to thereby make the inside of the protective cover 2 to have the air atmosphere. Afterwards, the air-side robot 8 is used to take out the protective cover 2 from the load lock chamber 12 and to transport the protective cover 2 to the cleaning chamber 10, where the protective cover 2 is cleaned (Step S16: protective cover cleaning step).

The positioning pins 2g and the reticle holding projections 2h which are provided on the lower cover 2b of the protective cover 2 contact with the reticle 1 when the reticle 1 is accommodated within the protective cover 2. Therefore, there is a high possibility that any dust might be generated in the vicinity of the positioning pins 2g and the reticle holding projection 2h. Any foreign matter (debris) generated due to the dust generation might adhere to the reticle holding projections 2h and the reticle 1. Further, there is a possibility that the foreign matter might accumulate on the protective cover 2 and the reticle 1 due to repeated unloading and loading of the reticle 1, and consequently the foreign matter might adhere even to the pattern region of the reticle 1, polluting or contaminating the pattern region of the reticle 1. When the pattern region of the reticle 1 is polluted or dirtied by foreign matter as described above, it is not possible to accurately expose the pattern of the reticle 1 onto the photosensitive substrate in the exposure section 3, thus lowering the conforming products rate of the produced semiconductor devices. Therefore, it is necessary to perform cleaning to remove any foreign matter generated due to the dust generation in the vicinity of the positioning pins 2g and the reticle holding projections 2h.

Various well known cleaning methods can be used as a specific cleaning method in Step S16. It is possible to use various cleaning methods such as wet cleaning, dry cleaning, cleaning in which wind is produced by a blower or the like to blow foreign matter off, etc. Essentially, any cleaning technique for removing, from the cover 2, a substance such as liquid, solid bodies, etc., which adversely affect the exposure, can be used as the cleaning of the present invention. For example, after performing ultrasonic cleaning (cleaning for approximately 3 minutes in an Absol liquid; cleaning for approximately 2 minutes in an alkali cleaning solution; and cleaning for approximately 1 minute in pure or purified water), drying (baking) may be performed. After performing the cleaning in Step S16, a particle counter or the like is used to confirm whether or not any foreign matter (dust, debris, etc.) is adhering. If any foreign matter is not adhering, the cleaning is completed. On the other hand, if any foreign matter is adhering, the cleaning is continued or performed again.

Next, the air-side robot 8 is used to take out the protective cover 2, for which the cleaning has been completed, from the cleaning chamber 10 and to load the cleaned protective cover 2 into the load lock chamber 12 (Step S17). Next, after the protective cover 2 is loaded again into the load lock chamber 12 in Step S17, the load lock chamber 12 is evacuated to make the interior of the load lock chamber 12 into vacuum atmosphere (Step S18). At this time, the interior of the protective cover 2 is also evacuated to have the vacuum atmosphere.

Next, the vacuum-side robot 16 is used to take out the protective cover 2 from the load lock chamber 12 and to load the protective cover 2 into the prealignment chamber 14. Then, the protective cover stands by until the reticle 1 is unloaded out of the exposure section 3 (Step S19). Upon unloading the reticle 1 from the exposure section 3, the vacuum-side robot 16 is used to unload the lower cover 2b out of the prealignment chamber 14, and to load the lower cover 2b into the exposure section 3. Then, in a state that the reticle 1 is covered by the lower cover 2b, the reticle 1 is carried to the prealignment chamber 14; then the lower cover 2b and the upper cover 2a are closed in the prealignment chamber 14 so as to accommodate the reticle 1 within protective cover 2. The reticle 1 accommodated in the protective cover 2 is unloaded to the outside of the vacuum atmosphere chamber via the load lock chamber 12.

According to the exposure apparatus of the first embodiment, foreign matter adhering to the protective cover 2 can be removed from the protective cover 2 because the exposure apparatus is provided with the cleaning chamber 10 in which the protective cover 2, covering at least a region of the reticle 1 having the pattern formed therein, is cleaned. Therefore, the protective cover 2 can be maintained in a clean state, and to prevent any foreign matter from adhering to the reticle 1, thereby realizing the satisfactory exposure. In particular, since it is possible to unload the protective cover 2 to the outside of the vacuum atmosphere chamber in a state that the reticle 1 is arranged within the clean atmosphere of the interior of the vacuum atmosphere chamber, the reticle 1 does not become polluted or dirtied when the protective cover 2 is cleaned.

Further, since the protective cover 2 is merely standing by while the reticle 1 is being used for the exposure, it is possible to use this idle time to clean the protective cover 2, thus exerting no adverse effects on the yield per unit time of the device to be produced.

In the first embodiment, the reticle transport section provided on the exposure apparatus has the cleaning chamber for cleaning the protective cover, and the protective cover is cleaned in the reticle transport section. However, in a case that the reticle transport section is not provided with any cleaning chamber, the protective cover may be cleaned at any another location.

Furthermore, in the first embodiment, the protective covers are prepared for the individual reticles respectively, corresponding thereto. However, it is also allowable that one protective cover is used to perform unloading and loading of a plurality of reticles. Namely, in the first embodiment, although the cleaned protective cover 2 is made to stand by in the prealignment chamber 14 so as to protect a certain reticle 1 to be unloaded out of the exposure section 3. However, the cleaned protective cover may protect another reticle to be loaded into the exposure section 3 and different from the certain reticle 1.

Moreover, in the first embodiment, the exposure is performed as the reticle processing. However, it is also possible to apply the present invention upon performing another processing for the reticle other than the exposure.

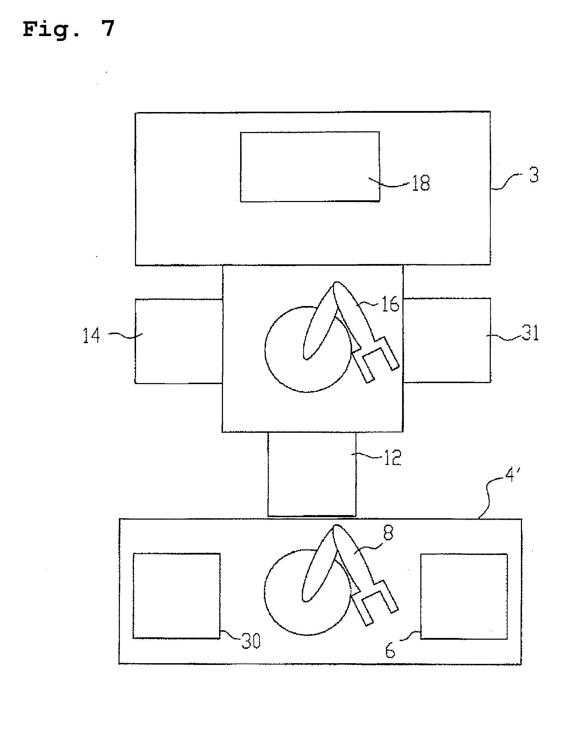

Next, an explanation will be given about an exposure apparatus according to a second embodiment of the invention with reference to the drawings. Fig. 7 shows the construction of the exposure apparatus according to the second embodiment. As shown in Fig. 7, the exposure apparatus according to the second embodiment has a construction approximately same as that of the exposure apparatus of the first embodiment shown in Fig. 1, except that this exposure apparatus includes a protective cover library 30 and a vacuum reticle library 31 in which reticles each covered by a protective cover are able to stand by. Accordingly, same reference numerals are affixed to same or similar constitutive parts or components for the convenience of explanation, and any explanation for the similar parts will be omitted.

Although the reticle transport section 4 of Fig. 1 has the cleaning chamber 10 arranged therein, a reticle transport section 4'of Fig. 7 has the protective cover library 30 therein, rather than the cleaning chamber. In the protective cover library 30, a plurality of cleaned protective covers are arranged. A protective cover 2, transported together with a reticle to the vacuum atmosphere via the load lock chamber 12, is separated from the reticle. After that, only the protective cover 2 is unloaded to the air side via the load lock chamber 12. The processes up to this point are similar to those of the first embodiment. In the second embodiment, instead of cleaning the protective cover 2, another protective cover arranged in the protective cover library 30 is used. Namely, another protective cover arranged in the protective cover library 30 is loaded into the interior of the vacuum atmosphere via the load lock chamber, and the anther protective cover covers the reticle 1 for which the exposure process has been completed. The reticle 1, covered by the protective cover, may standby in the vacuum reticle library 31, or the covered reticle 1 may be unloaded to the air-side as-is. By doing so, there is no need to arrange any cleaning chamber 10 beside the exposure apparatus, thereby realizing advantage in view of the footprint of the exposure apparatus. In addition, since it is possible to use a cleaned protective cover, it is possible to prevent pollution or contamination of the reticle.

When any ID information unique to the reticle, etc. is assigned to the protective cover 2, a device for rewriting the ID information (ID information rewriter) is preferably provided on the protective cover library 30 or arranged at a location other than in the protective cover library 30. For such rewriting, it is possible to use various well known techniques according to the type of ID information. For example, it is possible to mechanically replace an ID formed of a barcode or to use software to rewrite the ID information. The ID information is read by an unillustrated ID reader.

In each of the first and second embodiments, the reticle transport apparatus 4, 4' is arranged beside the load lock chamber 12. However, instead of this, it is possible, for example, to use a self-movable robot to transport the reticle, thereby realizing a construction in which all or part of the transport apparatus 4, 4' is not arranged beside the exposure apparatus. In this case, it is possible to share the air reticle library 6, the cleaning chamber 10, or the protective cover library 30 among a plurality of exposure apparatuses. By doing so, the footprint of the exposure apparatus in the clean room can be reduced, which is advantageous.

In each of the first and second embodiments, although the protective cover is cleaned or exchanged (replaced) each time the reticle and the protective cover are separated, the cleaning or exchange of the protective cover can be performed at any timing. For example, this timing can be determined based on the number of times that the reticle cover is used (it is possible to use, as the number of times of the protective cover usage, count of the number of times of attaching the protective cover to the reticle or the number of times of carrying the protective cover from the air to vacuum, etc.), time duration of usage of the protective cover, etc.

For example, a user inputs the timing for exchanging the protective cover (exchange timing) directly via a keyboard so that the exchange timing is stored in a storage section or memory arranged within a controller 40; and instructions for exchanging or cleaning is outputted from the controller 40 based on the stored data. The storage section may be arranged separately from the controller 40. Further, as a method for inputting the data to the storage section, the user may send the data via a network to the storage section. Furthermore, the data may be recorded in advance on a variety of recording media such as flexible disk, USB memory, etc.; and the recording media may be connected to the exposure apparatus as appropriate so that the data of exchange timing or cleaning timing is sent to the controller 40. Data such as the number of times, the time duration, etc. may be directly handled as the timing data. It is also possible, however, to input other parameters for computing these data to obtain and use the number of times or the time duration by calculations at the controller 40, or the like.

Further, a dust detecting device (debris detecting device) may be arranged which detects the presence or absence of dust, debris, etc. at or in the surrounding of the reticle holding projections 2h and the positioning pins 2g making contact with the reticle; and the exchange or cleaning of the reticle may be performed based on the results of dust (debris) detection. For example, a case that any foreign matter exists, or a case when the amount of the foreign matter exceeds a permissive value may be regarded as the exchange timing or cleaning timing. As such a dust detecting device, it is possible to use an optical dust detecting device 50 as shown in Fig. 5 and having a light source 51 and a detector 52 which detects light radiated from the light source 51 and reflected by the reticle cover. When foreign matter is present, the light is scattered by the foreign matter, which in turn changes the intensity of the light detected by the detector 52. Based on the change in the intensity, the presence or absence of the foreign matter can be detected. Any type of devices may be used as the foreign matter detection device provided that the device is capable of detecting a predetermined foreign matter. A commercially available particle counter may be used. In the example shown in Fig. 5, the foreign matter is detected in the prealignment chamber 14. However, the detection may be performed at a location other than the prealignment chamber 14. For example, as in the example shown in Fig. 7, such a foreign matter detection mechanism may be arranged in the vacuum reticle library 31 to perform the foreign matter detection.

The ID mark indicating characteristics unique to the reticle cover (the mark may be arranged to the cover fixedly or removably, and the mark may be a rewritable mark) is preferably managed as being associated with the ID of the reticle. This is because by doing so, when the reticle cover is stored at the outside the exposure apparatus in a state that the reticle is accommodated in the reticle cover, it is possible to judge which kind of reticle is accommodated in the reticle cover, based only on the ID number of the reticle cover. The ID may be readable by a device or machine, or the ID may be directly readable by an operator. Of course, such association is not necessary in a case that it is possible to directly confirm the type of reticle by making the reticle cover itself transparent or providing a window in the reticle cover through which the type of the reticle can be observed. Further, it is also possible to accommodate the reticle cover in a reticle SMIF pod (RSP) and manage the reticle based on an ID mark assigned to the RSP.

In a case that the ID of the reticle and the ID of the reticle cover are associated to perform the management and when the reticle cover is exchanged during the process as discussed above, it is preferable that the ID of a new reticle cover and the ID of a reticle accommodated in the new reticle cover are associated newly or that the ID of the new reticle cover is rewritten or exchanged.

It is preferable that the ID of a plurality of reticle covers are stored and that the reticle covers are managed so that determination can be made as to which reticle cover from among the plurality of reticle covers present is to be exchanged or cleaned. By doing so, even if a plurality of reticle covers are present, the exchange timing or cleaning timing can be determined independently for each of the reticle covers.

In the embodiments discussed above, the explanation was given in a case that the reticle process was exemplified by the exposure process. However, the present invention is applicable to a case that another process is performed for the reticle, for example, such as cleaning of the reticle.

A device such as a semiconductor device, is produced by performing a step of designing the function and the performance of the device; a step of manufacturing a reticle based on the designing step; a step for producing a wafer from a silicon material; a step of transferring and exposing the reticle pattern onto the wafer by the exposure apparatus of the above-described embodiments, etc; a step of assembling the device (including a dicing step, a bonding step, a packaging step, and the like); and an inspection step, etc.

As described above, the present invention can use a reticle in a clean state that any foreign matter is not adhering to the reticle. Therefore, in the exposure process, for example, a desired transfer can be performed, thereby making it possible to reduce the defect rate of the devices as final products.

Is should be noted that the above-described embodiments are intended for facilitating the understanding of the present invention, but not intended for limiting the present invention. Accordingly, the elements disclosed in the embodiments are each intended to encompass all design changes or modifications, equivalents, etc. belonging to the technical scope of the present invention.

The disclosure of the present invention is related to the subject matter included in Japanese Patent Application No. 2005-377668 filed on December 28, 2005, contents of which is explicitly incorporated herein by reference in its entirety.

### EMBODIMENTS

1. A reticle transport apparatus which transports a reticle with respect to a processing atmosphere chamber, the reticle transport apparatus comprising:
   a reticle loading mechanism which loads the reticle into the processing atmosphere chamber, at least a portion of the reticle being covered by a cover;
   a cover unloading mechanism which unloads, out of the processing atmosphere chamber, the cover which is separated from the reticle after the reticle has been loaded into the processing atmosphere chamber by the reticle loading mechanism; and
   a cover cleaning mechanism which cleans the cover unloaded by the cover unloading mechanism.
2. The reticle transport apparatus according feature 1, further comprising a cover mechanism which covers, with the cover cleaned by the cover cleaning mechanism, a reticle different from the reticle loaded into the processing atmosphere chamber or unloaded out of the processing atmosphere chamber.
3. The reticle transport apparatus according to feature 1, further comprising a cover mechanism which covers, in the processing atmosphere chamber, the reticle with the cover cleaned by the cover cleaning mechanism.
4. The reticle transport apparatus according to any one of features 1 to 3, wherein a processing atmosphere of the processing atmosphere chamber is a vacuum atmosphere.
5. The reticle transport apparatus according to any one of features 1 to 4, wherein the processing atmosphere chamber includes a load lock chamber in which an inner atmosphere of the load lock chamber changes between a vacuum atmosphere and an air atmosphere; and
   the reticle loading mechanism loads the reticle covered with the cover into the processing atmosphere chamber via the load lock chamber.
6. The reticle transport apparatus according to any one of features 1 to 3, wherein a processing atmosphere of the processing atmosphere chamber is an exposure atmosphere.
7. The reticle transport apparatus according to any one of features 1 to 6, wherein the cover covers at least a region of the reticle in which a pattern is formed.
8. The reticle transport apparatus according to any one of features 1 to 7, wherein the cover protects the reticle.
9. An exposure apparatus which transfers a pattern formed on a reticle onto a photosensitive substrate, the exposure apparatus comprising the reticle transport apparatus as defined in any one of features 1 to 8.
10. An exposure apparatus which transfers, onto a photosensitive substrate, a pattern formed on a reticle arranged in an exposure atmosphere chamber, the exposure apparatus comprising:
   a reticle loading mechanism which loads the reticle into the exposure atmosphere chamber, at least a portion of the reticle being covered by a cover;
   a cover separating mechanism which separates the cover from the reticle after the reticle has been loaded into the exposure atmosphere chamber by the reticle loading mechanism; and
   a cover unloading mechanism which unloads the cover out of the exposure atmosphere chamber while the reticle from which the cover has been separated by the cover separating mechanism remains in the exposure atmosphere chamber.
11. The exposure apparatus according to feature 10,
   wherein an exposure atmosphere of the exposure atmosphere chamber is a vacuum atmosphere.
12. The exposure apparatus according to feature 10 or 11,
   wherein the cover covers at least a region of the reticle in which the pattern is formed.
13. A reticle transporting method for transporting a reticle with respect to a processing atmosphere chamber, the method comprising:
   loading the reticle into the processing atmosphere chamber, at least a portion of the reticle being covered by a cover;
   unloading the cover, separated from the reticle after the reticle has been loaded into the processing atmosphere chamber, out of the processing atmosphere chamber; and
   cleaning the unloaded cover.
14. A reticle transporting method for transporting a reticle with respect to a processing atmosphere chamber, the method comprising:
   loading the reticle into the processing atmosphere chamber, at least a portion of the reticle being covered by a cover;
   separating the cover from the reticle in the processing atmosphere chamber; and
   unloading the cover out of the processing atmosphere chamber while the reticle from which the cover has been separated remains in the processing atmosphere chamber.
15. The reticle transporting method according to feature 13 or 14, wherein the cover covers at least a region of the reticle in which a pattern is formed.
16. A reticle processing method for performing a predetermined process for a reticle, the method comprising:
   transporting the reticle to a desired position, at least a portion of the reticle being covered with a cover;
   separating the cover and the reticle;
   performing the predetermined process for the separated reticle; and
   covering the reticle, for which the predetermined process has been performed, with a cover different from the cover.
17. The reticle processing method according to feature 16,
   wherein the predetermined process is exposure process for irradiating illumination light to the reticle and transferring and exposing a pattern formed on the reticle onto a photosensitive substrate.
18. The reticle processing method according to feature 16 or 17, wherein the cover and the reticle are separated in a clean atmosphere.
19. The reticle processing method according to feature 16 or 17, wherein the cover and the reticle are separated in a vacuum atmosphere.
20. The reticle processing method according to any one of features 16 to 19, wherein the cover covers at least a region of the reticle in which a pattern is formed.
21. An exposure apparatus which forms a pattern of a mask on an image plane, the exposure apparatus comprising control means for outputting timing of exchanging or cleaning a cover covering at least a portion of the mask.
22. The exposure apparatus according to feature 21, further comprising a storage section which stores characteristic unique to the cover.
23. The exposure apparatus according to feature 21 or 22, further comprising a sensor which detects presence or absence of dust adhering to the cover.
24. The exposure apparatus according to any one of features 21 to 23, further comprising a storage section which stores timing of exchanging or cleaning the cover.
25. A method for producing a device, comprising:
   using the reticle processing method as defined in feature 17; and
   producing the device from the photosensitive substrate exposed by the exposure process.
26. A method for managing a reticle cover, comprising determining timing of exchanging or cleaning the reticle cover using characteristic unique to the reticle cover.
27. The method according to feature 26, wherein the timing of exchanging or cleaning the reticle cover is determined based on a number of times of usage of the reticle cover.
28. The method according to feature 26, wherein the timing of exchanging or cleaning the reticle cover is determined based on a time duration of usage of the reticle cover.
29. The method according to feature 26, further comprising detecting presence or absence of foreign matter adhering to the reticle cover; and
   determining the timing of exchanging or cleaning the reticle cover based on a result of the detection.
30. The method according to any one of features 26 to 29, wherein the characteristic unique to the reticle cover is stored as being associated with characteristic unique to the reticle.
31. The method according to feature 30, wherein each of the characteristic unique to the reticle cover and the characteristic unique to the reticle is an ID mark.

## Claims

1. A reticle transport apparatus which transports a reticle with respect to a processing atmosphere chamber, the reticle transport apparatus comprising:
a reticle loading mechanism which loads the reticle into the processing atmosphere chamber, at least a portion of the reticle being covered by a cover;
a cover unloading mechanism which unloads, out of the processing atmosphere chamber, the cover which is separated from the reticle after the reticle has been loaded into the processing atmosphere chamber by the reticle loading mechanism; and
a cover cleaning mechanism which cleans the cover unloaded by the cover unloading mechanism.

2. The reticle transport apparatus according to claim 1, further comprising a cover mechanism which covers, with the cover cleaned by the cover cleaning mechanism, a reticle different from the reticle loaded into the processing atmosphere chamber or unloaded out of the processing atmosphere chamber.

3. The reticle transport apparatus according to claim 1, further comprising a cover mechanism which covers, in the processing atmosphere chamber, the reticle with the cover cleaned by the cover cleaning mechanism.

4. The reticle transport apparatus according to any one of claims 1 to 3, wherein a processing atmosphere of the processing atmosphere chamber is a vacuum atmosphere.

5. The reticle transport apparatus according to any one of claims 1 to 4, wherein the processing atmosphere chamber includes a load lock chamber in which an inner atmosphere of the load lock chamber changes between a vacuum atmosphere and an air atmosphere; and
the reticle loading mechanism loads the reticle covered with the cover into the processing atmosphere chamber via the load lock chamber.

6. The reticle transport apparatus according to any one of claims 1 to 3, wherein a processing atmosphere of the processing atmosphere chamber is an exposure atmosphere.

7. The reticle transport apparatus according to any one of claims 1 to 6, wherein the cover covers at least a region of the reticle in which a pattern is formed.

8. The reticle transport apparatus according to any one of claims 1 to 7, wherein the cover protects the reticle.

9. An exposure apparatus which transfers a pattern formed on a reticle onto a photosensitive substrate, the exposure apparatus comprising the reticle transport apparatus as defined in any one of claims 1 to 8.

10. A reticle transporting method for transporting a reticle with respect to a processing atmosphere chamber, the method comprising:
loading the reticle into the processing atmosphere chamber, at least a portion of the reticle being covered by a cover;
unloading the cover, separated from the reticle after the reticle has been loaded into the processing atmosphere chamber, out of the processing atmosphere chamber; and
cleaning the unloaded cover.

11. A reticle transporting method for transporting a reticle with respect to a processing atmosphere chamber, the method comprising:
loading the reticle into the processing atmosphere chamber, at least a portion of the reticle being covered by a cover;
separating the cover from the reticle in the processing atmosphere chamber; and
unloading the cover out of the processing atmosphere chamber while the reticle from which the cover has been separated remains in the processing atmosphere chamber.

12. The reticle transporting method according to claim 10 or 11, wherein the cover covers at least a region of the reticle in which a pattern is formed.
